# EUROPÄISCHE PATENTSCHRIFT

(11) **EP 3 128 348 B1**
(45) Veröffentlichungstag und Bekanntmachung des Hinweises auf die Patenterteilung: **15.08.2018**
(21) Anmeldenummer: 16172581.7
(22) Anmeldetag: 02.06.2016
(51) Int. Cl.: G01V 8/10, G01S 17/02, H01L 33/08

(54) **OPTOELEKTRONISCHER SENSOR**
OPTOELECTRONIC SENSOR
CAPTEUR OPTOÉLECTRONIQUE

(30) Priorität: 14.07.2015 DE 102015111379
(43) Veröffentlichungstag der Anmeldung: 08.02.2017
(73) Patentinhaber: SICK AG, 79183 Waldkirch/Breisgau (DE)
(72) Erfinder: Hörsch, Ingolf, 79102 Freiburg (DE); Merettig, Gerhard, 79350 Sexau (DE); Bergbach, Roland, 79367 Weisweil (DE); Lang, Felix, 79418 Schliengen (DE); Leuker, Günter, 79183 Waldkirch (DE)
(74) Vertreter: Manitz Finsterwald Patentanwälte PartmbB

(56) Entgegenhaltungen:
- DE-A1- 19 819 543
- DE-B3-102007 038 421
- DE-U1-202009 009 493
- US-A1- 2008 054 276
- US-A1- 2008 179 505

## Beschreibung

Die vorliegende Erfindung betrifft einen optoelektronischen Sensor zur Erkennung von Objekten oder Objekteigenschaften umfassend einen Lichtsender zum Aussenden von Sendelicht in einen Erfassungsbereich, einen Lichtempfänger zum Empfangen von Empfangslicht und eine Auswerteeinheit, die dazu ausgebildet ist, anhand des von dem Lichtempfänger empfangenen Empfangslichts ein in dem Erfassungsbereich befindliches oder in diesen hineinragendes Objekt zu erfassen und/oder eine Eigenschaft des solchen Objekts zu ermitteln.

Derartige Sensoren werden in vielfältiger Weise zum berührungslosen Detektieren von im Sichtbereich des Sensors vorhandenen Objekten eingesetzt. Beispielsweise dienen Lichttaster dazu, den Abstand einer Objektoberfläche von einer Bezugsebene des Sensors zu ermitteln. Mittels Lichtschranken oder Lichtgittern können zum Beispiel in einen abgesicherten Bereich eindringende Personen erkannt werden. Ein weiteres Einsatzgebiet von optoelektronischen Sensoren ist die Ermittlung bestimmter Eigenschaften von Objekten, beispielsweise in Form einer Farberkennung oder des Identifizierens von objektseitigen Markierungen oder Kennzeichen.

Üblicherweise umfasst der Lichtsender eines optoelektronischen Sensors eine Leuchtdiode oder einen Halbleiterlaser mit vergleichsweise geringer spektraler Linienbreite. Mit Lichtsendern, die infrarotes Licht emittieren, kann im Allgemeinen eine große Reichweite sowie eine hohe Empfindlichkeit des zugehörigen Sensors erzielt werden. Bei bestimmten Anwendungen wie zum Beispiel bei der Zugangskontrolle in öffentlichen Bereichen ist es außerdem erwünscht, dass der Messlichtstrahl unsichtbar ist. Allerdings ist bei fehlender Sichtbarkeit des Messlichtstrahls eine Ausrichtung des betreffenden Sensors im Rahmen der Montage erschwert. Dieses Problem kann im Prinzip durch einen zweiten, sichtbares Licht emittierenden Lichtsender gelöst werden, dessen Licht mit Hilfe von Strahlteilern, Lichtleitfasern oder dergleichen in den Strahlengang des Messlichts eingekoppelt wird. Dies ist jedoch mit einem beträchtlichen Aufwand und dementsprechenden Kosten verbunden. Außerdem beanspruchen der zusätzliche Lichtsender sowie die erforderlichen optischen Komponenten einen beträchtlichen Bauraum. Weiterhin reduzieren die optischen Komponenten die maximale Leistungsdichte sowie die Abbildungsschärfe.

Sensoren, die Licht in unterschiedlichen Wellenlängenbereichen mit jeweils geringer spektraler Linienbreite aussenden, sind in der US 2014/0307252A1, der DE 20 2009 012 589 U1, der EP 0 329 083 A2 und der DE 689 06 874 T2 offenbart.

Leuchtdioden mit mehreren unterschiedlich emittierenden Leuchtbereichen sind in der DE 10 2004 004 765 A1, der WO 99/57788 A2 und der US 2008/0211400 A1 offenbart.

In der DE 102 45 558 A1 ist ein Mikroskop-Objektiv offenbart, bei dem ein Beugungsgitter dazu eingesetzt wird, den Abbildungsfehler für das Untersuchungslicht zu korrigieren, ohne den Abbildungsfehler des Beobachtungslichts zu beeinträchtigen.

Die DE 10 2006 040 790 A1 offenbart einen Reflexkoppler, dessen Lichtsender eine oder mehrere organische Leuchtdioden auf einem strukturierten Substrat umfasst.

Es ist eine Aufgabe der Erfindung, einen optoelektronischen Sensor bereitzustellen, der leicht auszurichten ist, eine hohe Empfindlichkeit aufweist, wenig Bauraum beansprucht und kostengünstig herstellbar ist.

Die Lösung der Aufgabe erfolgt durch einen optoelektronischen Sensor mit den Merkmalen des Anspruchs 1.

Der Lichtsender eines erfindungsgemäßen optoelektronischen Sensors umfasst ein monolithisches Halbleiter-Bauelement mit einer ersten lichtemittierenden Schicht und einer zweiten lichtemittierenden Schicht, wobei die erste lichtemittierende Schicht zum Emittieren von rotem Licht ausgebildet ist und die zweite lichtemittierende Schicht zum Emittieren von infrarotem Licht ausgebildet ist. Die beiden lichtemittierenden Schichten können nebeneinander und/oder übereinander als vorzugsweise epitaktisch gewachsene Halbleiterkristallschichten auf ein Substrat aufgebracht sein. Das epitaktische Wachsen der beiden lichtemittierenden Schichten kann in separaten Prozessen erfolgen, wobei die beiden separat gewachsenen lichtemittierenden Schichten durch einen nachfolgenden verbindenden Prozess, z. B. einen Wafer-Bonding-Prozess, zu einem monolithischen Bauelement kombiniert werden.

Es wird also ein monolithisches Halbleiterbauelement - im Folgenden auch einfach "Chip" genannt - als Lichtsender bereitgestellt, das sowohl rotes als auch infrarotes Licht emittieren kann. Dadurch dass die Emission des roten Lichts und des infraroten Lichts von ein und demselben Chip aus erfolgt, also gewissermaßen von der gleichen Lichtquelle aus, ist der durch den Lichtsender beanspruchte Bauraum besonders gering. Zudem sind keine Strahlteiler oder dergleichen zum Zusammenführen der roten und der infraroten Lichtstrahlen erforderlich. Dies ist insbesondere deshalb vorteilhaft, da Strahlführungsoptiken nicht nur relativ viel Platz beanspruchen, sondern vor allem aufgrund ihrer Absorption die maximal erzielbare Leistungsdichte herabsetzen. Auch die Abbildungsqualität, also zum Beispiel die minimale Spotgröße, wird durch Strahlteiler und ähnliche optische Komponenten reduziert. Durch die Ausführung der beiden lichtemittierenden Bereiche als Schichten auf ein und demselben Halbleiter-Bauelement können die genannten Nachteile vermieden werden.

Vorzugsweise weist das monolithische Bauelement eine Kantenlänge von höchstens 1 mm auf. Der Lichtsender ist dann im Prinzip wie eine einzelne Leuchtdiode verwendbar.

Bei Bedarf kann zusätzlich zu der rot emittierenden Schicht wenigstens eine weitere rot emittierende Schicht vorgesehen sein. Ebenso kann zusätzlich zu der infrarot emittierenden Schicht wenigstens eine weitere infrarot emittierende Schicht vorgesehen sein. Außerdem kann es anwendungsbedingt erwünscht sein, außer einer rot emittierenden Schicht und einer infrarot emittierenden Schicht wenigstens eine weitere Schicht vorzusehen, die in einem von Rotlicht und Infrarotlicht separaten Wellenlängenbereich - beispielsweise im grünen Bereich - emittiert.

Die Erfindung sieht vor, dass die zweite lichtemittierende Schicht eine zentrale Leuchtfläche und die erste lichtemittierende Schicht eine die zentrale Leuchtfläche umschließende, äußere Lichtfläche definiert. Im Allgemeinen ist es günstig, wenn der infrarote Erfassungslichtstrahl als zentraler Strahl vorgesehen ist. Bei bestimmten Anwendungen könnte es dennoch bevorzugt sein, die erste lichtemittierende Schicht als zentrale Leuchtfläche und die zweite lichtemittierende Schicht als äußere Leuchtfläche auszubilden.

Dem Lichtsender ist erfindungsgemäß eine Steuereinrichtung zugeordnet, welche dazu ausgebildet ist, die erste lichtemittierende Schicht und die zweite lichtemittierende Schicht individuell anzusteuern. Die Steuereinrichtung kann hierfür über entsprechende elektrische Leitungen und mit den Schichten verbundene Kontakte an die lichtemittierenden Schichten angeschlossen sein. Durch die separaten Ansteuerungsmöglichkeiten der beiden lichtemittierenden Schichten ist die Flexibilität des Sensors erhöht.

Die Steuereinrichtung ist ferner erfindungsgemäß dazu ausgebildet, die erste lichtemittierende Schicht während des Betriebs des optoelektronischen Sensors lediglich zeitweise zu aktivieren. Unter einem "Aktivieren" einer lichtemittierenden Schicht ist hierbei sowohl ein Einschalten im Sinne eines Anregens zu dauerhaftem Leuchten als auch ein Versetzen in einen blinkenden oder aufblitzenden Zustand zu verstehen. Bei bestimmten Anwendungen ist es wünschenswert, das sichtbare rote Licht nicht ständig auszusenden.

Die Steuereinrichtung ist ferner erfindungsgemäß dazu ausgebildet, die erste lichtemittierende Schicht lediglich dann zu aktivieren, wenn sich der optoelektronische Sensor in einem Ausrichtmodus befindet und/oder wenn ein Schaltkriterium des optoelektronischen Sensors erfüllt ist und/oder wenn sich der optoelektronische Sensor in einem vorgegebenen Schaltzustand befindet. Unter einem Ausrichtmodus ist ein spezieller Betriebszustand eines optoelektronischen Sensors zu verstehen, welcher zum Ausrichten oder Justieren des Sensors in einer konkreten Anwendungssituation vorgesehen ist. Der rote Lichtstrahl dient in diesem Betriebszustand als Pilotlichtstrahl, der dem Benutzer die Position des Messlichtstrahls anzeigt. Als "Schaltkriterium" ist beispielsweise die Schaltschwelle eines Lichttasters anzusehen. Anhand des durch das Rotlicht kenntlich gemachten Schaltzustands kann ein Benutzer erkennen, ob der Sensor eingeschaltet oder abgeschaltet ist. Beispielsweise könnte beim Einschalten des Sensors ein einmaliges kurzes Aufleuchten der roten lichtemittierenden Schicht veranlasst werden. Der Benutzer weiß dann, dass der Einschaltvorgang erfolgreich war.

Eine Ausführungsform der Erfindung sieht vor, dass die erste lichtemittierende Schicht zum Emittieren von quasi-monochromatischem Licht im Wellenlängenbereich von 600 nm bis 780 nm ausgebildet ist und/oder dass die zweite lichtemittierende Schicht zum Emittieren von quasi-monochromatischem Licht im Wellenlängenbereich von mehr als 780 nm bis 2000 nm ausgebildet ist. Insbesondere können die lichtemittierenden Schichten jeweils für sich genommen wie die lichtemittierende Schicht einer herkömmlichen Leuchtdiode ausgestaltet sein.

Eine Ausgestaltung der Erfindung sieht vor, dass die erste lichtemittierende Schicht und die zweite lichtemittierende Schicht gestapelt, vorzugsweise direkt aufeinanderfolgend, auf ein gemeinsames Substrat des monolithischen Halbleiter-Bauelements aufgebracht sind. Aufgrund der gestapelten Anordnung ist es möglich, bei einem optoelektronischen Sensor eine koaxiale Anordnung von für die Messung verwendetem Erfassungslicht (infrarot) und zum Beispiel zum Ausrichten des Sensors verwendetem Pilotlicht (rot) vorzusehen, ohne hierfür Strahlteiler oder dergleichen zu benötigen.

Es ist bevorzugt, dass die dem Substrat nähere, untere lichtemittierende Schicht eine geringere Bandlücke aufweist als die vom Substrat weiter entfernte, obere lichtemittierende Schicht und/oder dass die zweite lichtemittierende Schicht die dem Substrat nähere, untere Schicht ist. Unabhängig von der Ausrichtung des Halbleiter-Bauelements wird hier diejenige lichtemittierende Schicht als unterste lichtemittierende Schicht bezeichnet, die sich zwischen dem Substrat und der anderen lichtemittierenden Schicht befindet. Die andere lichtemittierende Schicht ist dementsprechend als obere lichtemittierende Schicht anzusehen. Das von der unteren lichtemittierenden Schicht emittierte Licht muss wenigstens bereichsweise die obere lichtemittierende Schicht durchdringen und könnte daher in dieser absorbiert werden. Dadurch, dass die rot emittierende Schicht über der infrarot emittierenden Schicht angeordnet ist, können solche Absorptionsverluste weitgehend vermieden werden. Unter der Bandlücke wird allgemein die Energiedifferenz zwischen dem Valenzband und dem Leitungsband eines Halbleiters verstanden. Bei einer Leuchtdiode entspricht die Energie der emittierten Photonen gerade der Bandlücke. Wenn also die untere lichtemittierende Schicht eine geringere Bandlücke aufweist als die obere lichtemittierende Schicht, können die von der unteren Schicht emittierten Photonen beim Durchgang durch die obere Schicht nicht absorbiert werden.

Eine spezielle Ausgestaltung der Erfindung sieht vor, dass die vom Substrat weiter entfernte, obere lichtemittierende Schicht die dem Substrat nähere, untere lichtemittierende Schicht teilweise abdeckt, wobei in einem nicht abgedeckten Bereich der unteren lichtemittierenden Schicht wenigstens ein Mittenkontakt zur Kontaktierung der dem Substrat näheren, unteren lichtemittierenden Schicht angeordnet ist. Der Begriff "Mittenkontakt" wird hier für einen Anschlusskontakt einer Schicht verwendet, die keine äußere Schicht des Halbleiter-Bauelements ist. Aufgrund des Mittenkontakts ist eine selektive Ansteuerung der ersten lichtemittierenden Schicht und der zweiten lichtemittierenden Schicht möglich. Mit anderen Worten sind die rot emittierende Schicht und die infrarot emittierende Schicht individuell ansteuerbar. Der Mittenkontakt kann im Vergleich zur lichtemittierenden Gesamtfläche relativ klein ausgeführt sein, so dass trotz der individuellen Ansteuerbarkeit ein weitgehend gleich großer Lichtfleck für das rote Licht und für das infrarote Licht erzielbar ist.

Zwischen dem Substrat und der dem Substrat näheren, unteren lichtemittierenden Schicht kann wenigstens eine Spiegelschicht angeordnet sein, um das in Richtung des Substrats emittierte Licht zu reflektieren und somit zu nutzen.

Eine alternative Ausführungsform der Erfindung sieht vor, dass die erste lichtemittierende Schicht und die zweite lichtemittierende Schicht lateral räumlich voneinander getrennt sind. Bei dieser Ausgestaltung können beide lichtemittierenden Schichten direkt auf das Substrat aufgebracht sein, beispielsweise als epitaktische Schichten. Sie können für eine individuelle Ansteuerung einzeln kontaktiert sein.

Vorzugsweise sind die erste lichtemittierende Schicht und die zweite lichtemittierende Schicht konzentrisch auf einem gemeinsamen Substrat des monolithischen Halbleiter-Bauelements angeordnet. Hierdurch ist gewährleistet, dass die Position des infraroten Lichtstrahls relativ exakt anhand der Position des roten Lichtstrahls erkennbar ist.

Es kann vorgesehen sein, dass die zentrale Leuchtfläche kreisförmig oder oval ist und/oder dass die äußere Leuchtfläche geschlossen kreisringförmig oder segmentiert kreisringförmig ist. Speziell kann die äußere Leuchtfläche einen "Zielring" bilden, der von einem Benutzer unmittelbar als Ausrichthilfe verwendet wird.

Die Steuereinrichtung kann auch dazu ausgebildet sein, die erste lichtemittierende Schicht zu aktivieren, wenn eine Störung des Normalbetriebs vorliegt. Das rote Licht kann insofern als Warnsignal verwendet werden, um einen Benutzer auf beliebige Störungen, Fehler oder Gefahren hinzuweisen.

Es ist bevorzugt, dass das monolithische Halbleiter-Bauelement die einzige Lichtquelle des Lichtsenders bildet. Hierdurch können Herstellungskosten, Gewicht und Bauraum gespart werden.

Der Lichtsender kann eine farbkorrigierte Sendeoptik umfassen, insbesondere wobei die farbkorrigierte Sendeoptik für das von der ersten lichtemittierenden Schicht emittierte rote Licht und für das von der zweiten lichtemittierenden Schicht emittierte infrarote Licht zumindest im Wesentlichen die gleiche Brennweite aufweist. Dadurch wird erreicht, dass die Strahlformung für beide Wellenlängen im Wesentlichen von gleicher Qualität ist.

Der Lichtsender kann als Achromat ausgeführt sein, im einfachsten Fall z. B. als zweilinsiges Objektiv.

Eine besonders kostengünstige Ausgestaltung der Erfindung sieht vor, dass der Achromat eine Kombination aus einer refraktiven optischen Struktur und einer diffraktiven optischen Struktur umfasst und/oder aus Kunststoff gefertigt ist. Beispielsweise kann der Achromat eine Kunststofflinse mit einer diffraktiven Kompensationsfläche umfassen und insbesondere ausschließlich durch eine solche Kunststofflinse gebildet sein.

Der optoelektronische Sensor kann z. B. als optischer Taster, beispielsweise als Wechsellicht-Taster, Triangulationstaster, Lumineszenztaster oder Kontrasttaster ausgebildet sein. Unter einem optischen Taster ist insbesondere ein Lichttaster zu verstehen, der anhand des von einem Objekt reflektierten Lichts dessen Vorhandensein und gegebenenfalls dessen Abstand erkennt.

Alternativ kann ein erfindungsgemäßer optoelektronischer Sensor als Einweg-Lichtschranke oder als Reflexionslichtschranke ausgebildet sein.

Ein erfindungsgemäßer optoelektronischer Sensor kann auch als Farbsensor ausgebildet sein.

Weiterbildungen der Erfindung sind auch in den abhängigen Ansprüchen, der Beschreibung sowie der beigefügten Zeichnung angegeben.

Die Erfindung wird nachfolgend beispielhaft anhand der Zeichnung beschrieben.
- Fig. 1: ist eine Prinzipdarstellung einer Ausgestaltung eines erfindungsgemäßen optoelektronischen Sensors.
- Fig. 2: zeigt schematisch den Lichtsender eines optoelektronischen Sensors gemäß einer ersten Ausführungsform der Erfindung.
- Fig. 3: zeigt den Lichtsender eines optoelektronischen Sensors gemäß einer zweiten Ausführungsform der Erfindung.
- Fig. 4: zeigt den Lichtsender eines optoelektronischen Sensors gemäß einer dritten Ausführungsform der Erfindung.
- Fig. 5: ist eine Draufsicht auf den Lichtsender gemäß Fig. 4.
- Fig. 6: ist eine Draufsicht auf den Lichtsender gemäß Fig. 4, wobei das Aspektverhältnis der zentralen lichtemittierenden Schicht gegenüber Fig. 5 abgewandelt ist.

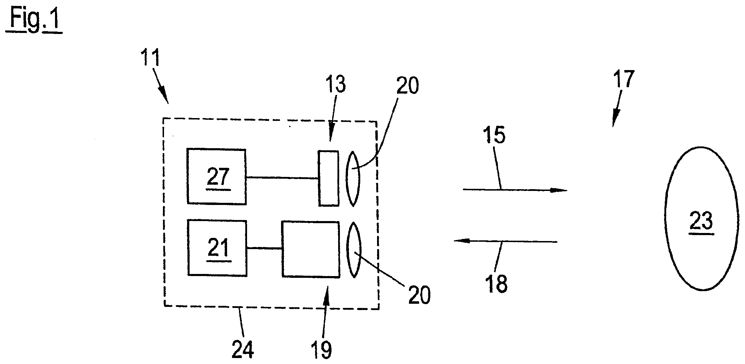

Der in Fig. 1 lediglich schematisch dargestellte optoelektronische Sensor 11, hier in der Ausgestaltung als Lichttaster, umfasst einen Lichtsender 13, welcher dazu ausgebildet ist, Sendelichtstrahlen 15 in einen Erfassungsbereich 17 auszusenden. Ein in dem Erfassungsbereich 17 vorhandenes Objekt 23 reflektiert oder remittiert die Sendelichtstrahlen 15, welche dann als Empfangslichtstrahlen 18 auf einen Lichtempfänger 19 des optoelektronischen Sensors 11 gelangen. Bei dem Lichtempfänger 19 kann es sich um eine Fotodiode oder um einen ortsauflösenden Detektor wie eine Diodenzeile oder ein CCD-Array handeln. Dem Lichtsender 13 und dem Lichtempfänger 19 sind jeweilige Strahlformungsoptiken 20 zugeordnet, welche jedoch nicht für jede Sensoranwendung zwingend sind.

Eine elektronische Auswerteeinheit 21 steht mit dem Lichtempfänger 19 in Verbindung und ist in der Lage, anhand der von dem Lichtempfänger 19 empfangenen Empfangslichtstrahlen 18 in an sich bekannter Weise das Objekt 23 zu detektieren und/oder eine Eigenschaft des Objekts 23 wie dessen Farbe zu ermitteln. Der Lichtsender 13 und der Lichtempfänger 19 können wie in Fig. 1 dargestellt in ein gemeinsames Sensorgehäuse 24 integriert sein. Grundsätzlich können der Lichtsender 13 und der Lichtempfänger 19 jedoch auch in getrennten Komponenten untergebracht sein, wenn beispielsweise eine Einweg-Lichtschranke bereitgestellt werden soll.

Der Lichtsender 13 steht mit einer elektronischen Steuereinrichtung 27 in Verbindung und ist durch diese selektiv aktivierbar.

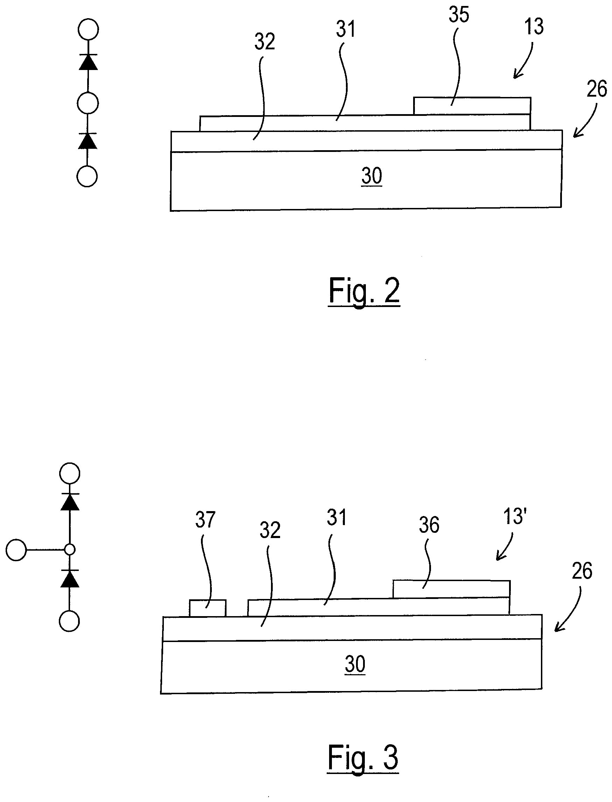

Wie in Fig. 2 vereinfacht dargestellt umfasst der Lichtsender 13 ein monolithisches Halbleiter-Bauelement 26 mit einem Substrat 30, einer ersten lichtemittierenden Schicht 31 sowie einer zweiten lichtemittierenden Schicht 32. Bei den beiden lichtemittierenden Schichten 31, 32 handelt es sich um epitaktisch auf das Substrat 30 aufgebrachte Halbleiterschichten, welche jeweils zum Emittieren von quasi-monochromatischem Licht ausgebildet sind. Während jedoch die dem Substrat 30 nähere, in Fig. 2 untere lichtemittierende Schicht 32 zum Emittieren von infrarotem Licht ausgebildet ist, ist die vom Substrat 30 weiter entfernte, in Fig. 2 obere lichtemittierende Schicht 31 zum Emittieren von rotem Licht ausgebildet. Die obere lichtemittierende Schicht 31 weist somit eine größere Bandlücke auf als die untere lichtemittierende Schicht 32, so dass die von der unteren lichtemittierenden Schicht 32 emittierten Photonen beim Durchgang durch die obere lichtemittierende Schicht 31 nicht absorbiert werden. Die beiden lichtemittierenden Schichten 31, 32 sind in grundsätzlich bekannter Weise über einen elektrischen Kontakt 35 mit der elektronischen Steuereinrichtung 27 (Fig. 1) verbunden. Als Masse dient z. B. in an sich bekannter Weise das Substrat 30. Zur Erläuterung ist im linken Bereich von Fig. 2 das dem Lichtsender 13 entsprechende Schaltsymbol angegeben.

Bei der in Fig. 2 dargestellten Ausführungsform der Erfindung sind die beiden lichtemittierenden Schichten 31, 32 direkt aufeinanderfolgend gestapelt auf dem Substrat 30 angeordnet. Grundsätzlich könnten sich jedoch auch eine oder mehrere zusätzliche lichtemittierende Schichten zwischen den beiden lichtemittierenden Schichten 31, 32 befinden. Um die Lichtausbeute zu erhöhen, könnte zwischen dem Substrat 30 und der unteren lichtemittierenden Schicht 32 eine Spiegelschicht angeordnet sein, was in Fig. 2 jedoch nicht dargestellt ist.

Der in Fig. 3 dargestellte, gemäß einer alternativen Ausführungsform der Erfindung gestaltete Lichtsender 13' ist im Prinzip aufgebaut wie der vorstehend in Bezug auf Fig. 2 beschriebene Lichtsender 13, weist jedoch anstelle eines gemeinsamen elektrischen Kontaktes 35 zwei separate Kontakte 36, 37 auf, die den beiden Schichten 31, 32 zugeordnet sind. Derjenige Kontakt 37, welcher der unteren lichtemittierenden Schicht 32 zugeordnet ist, ist dabei als Mittenkontakt ausgeführt. Die obere lichtemittierende Schicht 31 deckt hier also die untere lichtemittierende Schicht 32 lediglich teilweise ab, wobei der als Mittenkontakt ausgeführte Kontakt 37 in einem nicht abgedeckten Bereich auf der unteren lichtemittierenden Schicht 32 angeordnet ist. Aufgrund der separaten Kontaktierung sind die beiden lichtemittierenden Schichten 31, 32 bei der in Fig. 3 dargestellten Ausführungsform individuell ansteuerbar.

Bei den in Fig. 2 und 3 gezeigten Lichtsendern 13, 13' wird durch die lichtemittierenden Schichten 31, 32 jeweils eine zentrale Leuchtfläche und eine äußere Leuchtfläche definiert. Deshalb ist in Fig. 2 und 3 die untere lichtemittierende Schicht 32 größer dargestellt als die obere lichtemittierende Schicht 31.

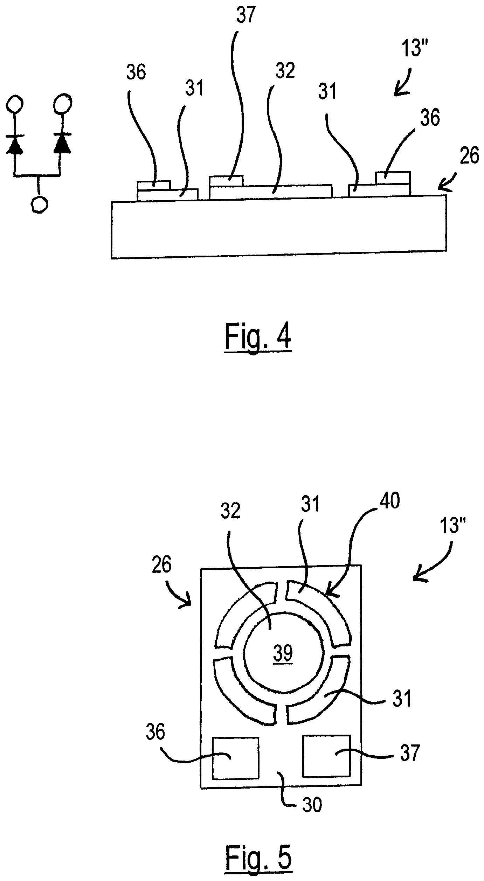

Fig. 4 zeigt eine weitere Ausführungsform eines Lichtsenders 13" für einen erfindungsgemäßen optoelektronischen Sensor 11. Bei dieser Ausführungsform sind die beiden lichtemittierenden Schichten 31, 32 ebenfalls über separate Kontakte 36, 37 mit der Steuereinrichtung 27 (Fig. 1) verbunden und daher individuell ansteuerbar. Die beiden Schichten 31, 32 sind hier jedoch nicht gestapelt angeordnet, sondern lateral räumlich voneinander getrennt. Mit anderen Worten ist sowohl die erste lichtemittierende Schicht 31 als auch die zweite lichtemittierende Schicht 32 direkt auf das Substrat 30 aufgebracht. Bei Bedarf könnte aber auch hier eine Spiegelschicht oder andere Schichten zwischen dem Substrat 30 und den lichtemittierenden Schichten 31, 32 vorgesehen sein. Bei der in Fig. 4 gezeigten Ausführungsform ist es nicht möglich, den roten Lichtstrahl und den infraroten Lichtstrahl exakt koaxial auszusenden. Es ist jedoch bevorzugt, die erste lichtemittierende Schicht 31 und die zweite lichtemittierende Schicht 32 konzentrisch auf dem Substrat 30 anzuordnen, so dass sich eine weitgehend koaxiale Abstrahlung von rotem Licht und infrarotem Licht ergibt.

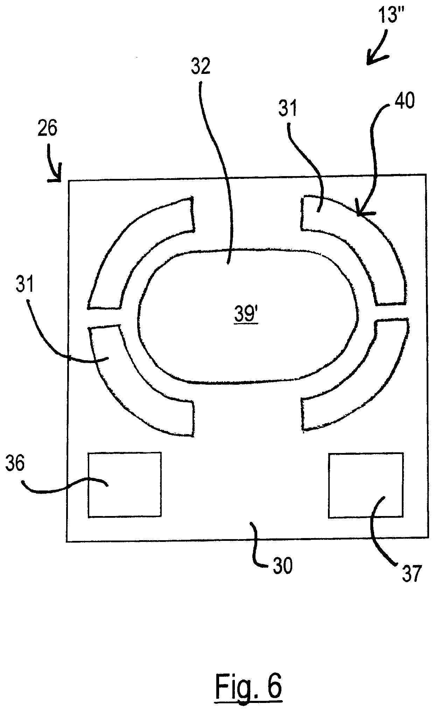

Beispielsweise kann die zweite lichtemittierende Schicht 32 wie in Fig. 5 und 6 gezeigt eine zentrale Leuchtfläche 39 definieren, wohingegen die erste lichtemittierende Schicht 31 eine die zentrale Leuchtfläche 39 umschließende äußere Leuchtfläche 40 definiert. Bei der in Fig. 5 gezeigten Ausführungsform ist die zentrale Leuchtfläche 39 kreisförmig und die äußere Leuchtfläche 40 ist segmentiert kreisringförmig. Demgegenüber ist bei der in Fig. 6 dargestellten Ausführungsform die zentrale Leuchtfläche 39' oval. Aufgrund der ovalen Form der zentralen Leuchtfläche 39' ist es möglich, auf einem linearen Lichtempfangselement eine höhere Energiedichte zu erzielen und somit zum Beispiel die Tastweite eines als Lichttaster ausgeführten optoelektronischen Sensors 11 zu erhöhen. Für die äußere, rote Leuchtfläche 40 ist es ausreichend, dass eine segmentiert kreisförmige Gestalt wie bei der Ausführungsform gemäß Fig. 5 vorliegt, da die rote Leuchtfläche 40 für den eigentlichen Erfassungsvorgang nicht maßgeblich ist. Vielmehr wird der rote Lichtstrahl bevorzugt lediglich als "Zielring" zum Ausrichten des optischen Sensors 11 herangezogen. Um ein besonders einfaches Ausrichten im Sinne eines Zielens zu ermöglichen, könnte gemäß einem nicht dargestellten Ausführungsbeispiel die erste lichtemittierende Schicht 31 auch z. B. kreuzförmig sein.

Wie vorstehend erwähnt ist der in Fig. 3 dargestellte Lichtsender 13' ebenso wie der in Fig. 4-6 dargestellte Lichtsender 13" derart betreibbar, dass je nach Betriebszustand ausschließlich rotes Licht, ausschließlich infrarotes Licht oder gleichzeitig rotes Licht und infrarotes Licht ausgesendet wird. Für viele Anwendungen ist es vorteilhaft, dass das rote Licht lediglich zeitweise ausgesendet wird. Zu diesem Zweck kann die erste lichtemittierende Schicht 31 beispielsweise lediglich dann aktiviert werden, wenn sich der optoelektronische Sensor 11 in einem Ausrichtmodus befindet. Der Sensor 11 kann beispielsweise durch einen Benutzer per Knopfdruck in den Ausrichtmodus versetzt werden. Nach Beendigung des Ausrichtens kann der Benutzer - beispielsweise ebenfalls per Knopfdruck - den Sensor 11 in einen Normalbetriebszustand versetzen, in welchem lediglich die zweite lichtemittierende Schicht 32 aktiviert wird und dementsprechend lediglich infrarotes Licht emittiert wird.

Eine alternative Ausführungsform sieht vor, dass beim Einschalten des optoelektronischen Sensors 11 ein kurzer roter Lichtpuls ausgesendet wird, um dem Benutzer die Betriebsbereitschaft des optoelektronischen Sensors 11 anzuzeigen. Es könnte auch ein Deaktivieren der ersten lichtemittierenden Schicht 31 entsprechend einem Abschalten des roten Lichts veranlasst werden, sobald eine Schaltschwelle des Sensors 11 erreicht ist. Dies kann den Einstellvorgang weiter erleichtern. Die erste lichtemittierende Schicht 31 könnte auch bei Vorliegen einer Störung oder bei einem detektierten Gefahrenszenario aktiviert werden, wobei der rote Lichtstrahl als Warnsignal dient. Dazu kann auch zum Beispiel ein pulsierender Betrieb vorgesehen sein, so dass der Eindruck eines Blinklichtes entsteht.

Um die vorstehend angegebenen spezifischen Betriebsmodi zu implementieren, kann ein erfindungsgemäßer optischer Sensor 11 eine übergeordnete, mit der Auswerteeinheit 21 und der Steuereinrichtung 27 in Verbindung stehende Steuereinheit umfassen, welche in Fig. 1 jedoch nicht dargestellt ist.

Vorzugsweise ist dem Lichtsender 13 ein Achromat als Strahlformungsoptik 20 zugeordnet, welcher für das von der ersten lichtemittierenden Schicht 31 emittierte rote Licht und für das von der zweiten lichtemittierenden Schicht 32 emittierte infrarote Licht die gleiche Brennweite aufweist. Der Achromat kann als Kunststofflinse mit diffraktiver Kompensationsfläche ausgeführt sein.

Allgemein kann ein erfindungsgemäßer optischer Sensor 11 als optischer Taster, beispielsweise als Wechsellichttaster (WT), Lumineszenztaster (LT), Triangulationstaster - vorzugsweise mit Hintergrundausblendung (HGA) - oder als Kontrasttaster (KT) ausgebildet sein. Alternativ könnte ein erfindungsgemäßer optischer Sensor 11 auch als Lichtschranke, Lichtgitter oder als Farbsensor (CS) ausgebildet sein.

Dadurch, dass der Lichtsender 13, 13', 13" zwei auf ein und demselben Chip aufgebrachte epitaktische Schichten als Lichtquellen aufweist, kann ein Messen im infraroten Spektralbereich und ein Ausrichten im sichtbaren roten Spektralbereich erfolgen, ohne dass hierfür separate Leuchtdioden oder Strahlvereinigungsoptiken bereitgestellt werden müssen. Die Erfindung ermöglicht somit eine besonders zuverlässige und empfindliche Objekterkennung sowie eine einfache Sensorausrichtung bei gleichzeitiger Einsparung von Herstellungskosten, Gewicht und Bauraum.

### Bezugszeichenliste

- 11: optischer Sensor
- 13, 13', 13": Lichtsender
- 15: Sendelichtstrahlen
- 17: Erfassungsbereich
- 18: Empfangslichtstrahlen
- 19: Lichtempfänger
- 20: Strahlformungsoptik
- 21: Auswerteeinheit
- 23: Objekt
- 24: Sensorgehäuse
- 26: Halbleiter-Bauelement
- 27: Steuereinrichtung
- 30: Substrat
- 31: erste lichtemittierende Schicht
- 32: zweite lichtemittierende Schicht
- 35: gemeinsamer elektrischer Kontakt
- 36: separater elektrischer Kontakt
- 37: separater elektrischer Kontakt
- 39, 39': zentrale Leuchtfläche
- 40: äußere Leuchtfläche

## Patentansprüche

1. Optoelektronischer Sensor (11) zur Erkennung von Objekten (23) oder Objekteigenschaften umfassend einen Lichtsender (13, 13', 13") zum Aussenden von Sendelicht in einen Erfassungsbereich (17), einen Lichtempfänger (19) zum Empfangen von Empfangslicht und eine Auswerteeinheit (21), die dazu ausgebildet ist, anhand des von dem Lichtempfänger (19) empfangenen Empfangslichts ein in dem Erfassungsbereich (17) befindliches oder in diesen hineinragendes Objekt (23) zu erfassen und/oder eine Eigenschaft eines solchen Objekts zu ermitteln, wobei
der Lichtsender (13, 13', 13") ein monolithisches Halbleiter-Bauelement (26) mit einer ersten lichtemittierenden Schicht (31) und einer zweiten lichtemittierenden Schicht (32) umfasst, und wobei die zweite lichtemittierende Schicht (32) eine zentrale Leuchtfläche (39, 39') und die erste lichtemittierende Schicht (31) eine die zentrale Leuchtfläche (39, 39') umschließende, äußere Leuchtfläche (40) definiert,
**dadurch gekennzeichnet, dass**
die erste lichtemittierende Schicht (31) zum Emittieren von rotem Licht ausgebildet ist und die zweite lichtemittierende Schicht (32) zum Emittieren von infrarotem Licht ausgebildet ist, dass
dem Lichtsender (13) eine Steuereinrichtung (27) zugeordnet ist, welche dazu ausgebildet ist, die erste lichtemittierende Schicht (31) und die zweite lichtemittierende Schicht (32) individuell anzusteuern, und dass die Steuereinrichtung (27) dazu ausgebildet ist, die erste lichtemittierende Schicht (31) während des Betriebs des optoelektronischen Sensors (11) lediglich zeitweise zu aktivieren, wobei
die Steuereinrichtung (27) dazu ausgebildet ist, die erste lichtemittierende Schicht (31) lediglich dann zu aktivieren, wenn sich der optoelektronische Sensor (11) in einem Ausrichtmodus befindet und/oder wenn ein Schaltkriterium des optoelektronischen Sensors (11) erfüllt ist und/oder wenn sich der optoelektronische Sensor (11) in einem vorgegebenen Schaltzustand befindet.

2. Optoelektronischer Sensor nach Anspruch 1,
**dadurch gekennzeichnet, dass**
die erste lichtemittierende Schicht (31) zum Emittieren von quasi-monochromatischem Licht im Wellenlängenbereich von 600 nm bis 780 nm ausgebildet ist und/oder dass
die zweite lichtemittierende Schicht (32) zum Emittieren von quasi-monochromatischem Licht im Wellenlängenbereich von mehr als 780 nm bis 2000 nm ausgebildet ist.

3. Optoelektronischer Sensor nach Anspruch 1 oder 2,
**dadurch gekennzeichnet, dass**
die erste lichtemittierende Schicht (31) und die zweite lichtemittierende Schicht (32) gestapelt, vorzugsweise direkt aufeinanderfolgend, auf ein gemeinsames Substrat (30) des monolithischen Halbleiter-Bauelements (26) aufgebracht sind.

4. Optoelektronischer Sensor nach Anspruch 3,
**dadurch gekennzeichnet, dass**
die dem Substrat (30) nähere, untere lichtemittierende Schicht (32) eine geringere Bandlücke aufweist als die vom Substrat (30) weiter entfernte, obere lichtemittierende Schicht (31) und/oder dass die zweite lichtemittierende Schicht (32) die dem Substrat (30) nähere, untere Schicht ist.

5. Optoelektronischer Sensor nach einem der Ansprüche 3 oder 4,
**dadurch gekennzeichnet, dass**
zwischen dem Substrat (30) und der dem Substrat (30) näheren, unteren lichtemittierenden Schicht (32) wenigstens eine Spiegelschicht angeordnet ist.

6. Optoelektronischer Sensor nach einem der Ansprüche 3 bis 5,
**dadurch gekennzeichnet, dass**
die vom Substrat (30) weiter entfernte, obere lichtemittierende Schicht (31) die dem Substrat (30) nähere, untere lichtemittierende Schicht (32) lediglich teilweise abdeckt, wobei in einem nicht abgedeckten Bereich der unteren lichtemittierenden Schicht (32) wenigstens ein Mittenkontakt (37) zur Kontaktierung der dem Substrat (30) näheren, unteren lichtemittierenden Schicht (32) angeordnet ist.

7. Optoelektronischer Sensor nach einem der Ansprüche 1 oder 2,
**dadurch gekennzeichnet, dass** die erste lichtemittierende Schicht (31) und die zweite lichtemittierende Schicht (32) lateral räumlich voneinander getrennt sind.

8. Optoelektronischer Sensor nach einem der vorstehenden Ansprüche,
**dadurch gekennzeichnet, dass**
die zentrale Leuchtfläche (39, 39') kreisförmig oder oval ist und/oder dass die äußere Leuchtfläche (40) geschlossen kreisringförmig oder segmentiert kreisringförmig ist.

9. Optoelektronischer Sensor nach einem der vorstehenden Ansprüche,
**dadurch gekennzeichnet, dass**
die erste lichtemittierende Schicht (31) und die zweite lichtemittierende Schicht (32) konzentrisch auf einem gemeinsamen Substrat (30) des monolithischen Halbleiter-Bauelements (26) angeordnet sind.

10. Optoelektronischer Sensor nach einem der vorstehenden Ansprüche,
**dadurch gekennzeichnet, dass**
das monolithische Halbleiter-Bauelement (26) die einzige Lichtquelle des Lichtsenders (13) bildet.

11. Optoelektronischer Sensor nach einem der vorstehenden Ansprüche,
**dadurch gekennzeichnet, dass**
der Lichtsender (13) eine farbkorrigierte Sendeoptik (20) umfasst, insbesondere wobei die farbkorrigierte Sendeoptik (20) für das von der ersten lichtemittierenden Schicht (31) emittierte rote Licht und für das von der zweiten lichtemittierenden Schicht (32) emittierte infrarote Licht zumindest im Wesentlichen die gleiche Brennweite aufweist.

12. Optoelektronischer Sensor nach Anspruch 11,
**dadurch gekennzeichnet, dass**
der Lichtsender (13) als Achromat ausgeführt ist, wobei der Achromat vorzugsweise eine Kombination aus einer refraktiven optischen Struktur und einer diffraktiven optischen Struktur umfasst und/oder aus Kunststoff gefertigt ist.

13. Optoelektronischer Sensor nach einem der vorstehenden Ansprüche,
**dadurch gekennzeichnet, dass**
der optoelektronische Sensor (11) als optischer Taster, beispielsweise als Wechsellicht-Taster, Triangulationstaster, Lumineszenztaster oder Kontrasttaster, ausgebildet ist oder dass
der optoelektronische Sensor (11) als Ein-Weg-Lichtschranke oder als Reflexionslichtschranke ausgebildet ist oder dass
der optoelektronische Sensor (11) als Farbsensor ausgebildet ist.

## Claims

1. An optoelectronic sensor (11) for recognizing objects (23) or object properties comprising a light transmitter (13, 13', 13") for transmitting transmitted light into a detection zone (17); a light receiver (19) for receiving received light; and an evaluation unit (21) which is configured to detect an object (23) located in or projecting into the detection zone (17) and/or to determine a property of such an object with reference to the received light received by the light receiver (19), wherein
the light transmitter (13, 13', 13") comprises a monolithic semi-conductor component (26) having a first light emitting layer (31) and a second light emitting layer (32), and wherein the second light emitting layer (32) defines a central light emitting surface (39, 39') and the first light emitting layer (31) defines an outer light emitting surface (40) surrounding the central light emitting surface (39, 39'),
**characterized in that**
the first light emitting layer (31) is configured for emitting red light and the second light emitting layer (32) is configured for emitting infrared light; **in that**
a control device (27) which is configured to individually control the first light emitting layer (31) and the second light emitting layer (32) is associated with the light transmitter (13); and **in that**
the control device (27) is configured to activate the first light emitting layer (31) only part time during the operation of the optoelectronic sensor (11), with
the control device (27) being configured only to activate the first light emitting layer (31) when the optoelectronic sensor (11) is in an alignment mode and/or when a switching condition of the optoelectronic sensor (11) is satisfied and/or when the optoelectronic sensor (11) is in a predefined switching state.

2. An optoelectronic sensor in accordance with claim 1,
**characterized in that**
the first light emitting layer (31) is configured for emitting quasi-monochromatic light in the wavelength range from 600 nm to 780 nm; and/or **in that**
the second light emitting layer (32) is configured for emitting quasi-monochromatic light in the wavelength range from more than 780 nm to 2000 nm.

3. An optoelectronic sensor in accordance with claim 1 or claim 2,
**characterized in that**
the first light emitting layer (31) and the second light emitting layer (32) are applied to a common substrate (30) of the monolithic semiconductor component (26) in a stacked manner, preferably directly after one another.

4. An optoelectronic sensor in accordance with claim 3,
**characterized in that**
the lower light emitting surface (32) closer to the substrate (30) has a smaller band gap than the upper light emitting layer (31) further remote from the substrate (30); and/or **in that** the second light emitting layer (32) is the lower layer closer to the substrate (30).

5. An optoelectronic sensor in accordance with one of the claims 3 or 4,
**characterized in that**
at least one mirror layer is arranged between the substrate (30) and the lower light emitting layer (32) closer to the substrate (30).

6. An optoelectronic sensor in accordance with any one of the claims 3 to 5,
**characterized in that**
the upper light emitting layer (31) further remote from the substrate (30) only partly covers the lower light emitting layer (32) closer to the substrate (30), with at least one middle contact (37) for contacting the lower light emitting layer (32) closer to the substrate (30) being arranged in a non-covered region of the lower light emitting layer (32).

7. An optoelectronic sensor in accordance with one of the claims 1 or 2,
**characterized in that**
the first light emitting layer (31) and the second light emitting layer (32) are laterally spatially separate from one another.

8. An optoelectronic sensor in accordance with any one of the preceding claims,
**characterized in that**
the central light emitting surface (39, 39') is circular or oval; and/or **in that** the outer light emitting surface (40) is of closed annular shape or segmented annular shape.

9. An optoelectronic sensor in accordance with any one of the preceding claims,
**characterized in that**
the first light emitting layer (31) and the second light emitting layer (32) are arranged concentrically on a common substrate (30) of the monolithic semiconductor component (26).

10. An optoelectronic sensor in accordance with any one of the preceding claims,
**characterized in that**
the monolithic semiconductor component (26) forms the only light source of the light transmitter (13).

11. An optoelectronic sensor in accordance with any one of the preceding claims,
**characterized in that**
the light transmitter (13) comprises a color-corrected transmission optics (20), with the color-corrected transmission optics (20) in particular having at least substantially the same focal length for the red light emitted by the first light emitting layer (31) and for the infrared light emitted by the second light emitting layer (32).

12. An optoelectronic sensor in accordance with claim 11,
**characterized in that**
the light transmitter (13) is designed as an achromatic lens, with the achromatic lens preferably comprising a combination of a refractive optical structure and of a diffractive optical structure and/or being produced from plastic.

13. An optoelectronic sensor in accordance with any one of the preceding claims,
**characterized in that**
the optoelectronic sensor (11) is configured as an optical sensor, for example as a changing light sensor, a triangulation sensor, a luminescence sensor or a contrast sensor; or **in that**
the optoelectronic sensor (11) is configured as a unidirectional light barrier or as a reflected light barrier; or **in that**
the optoelectronic sensor (11) is configured as a color sensor.

## Revendications

1. Capteur optoélectronique (11) pour reconnaître des objets (23) ou des propriétés d'objet, comportant un émetteur de lumière (13, 13', 13") pour émettre une lumière d'émission dans une zone de détection (17), un récepteur de lumière (19) pour recevoir une lumière de réception, et une unité d'évaluation (21) qui est réalisée pour détecter un objet (23) situé dans la zone de détection (17) ou pénétrant dans celle-ci et/ou une propriété d'un tel objet, en se basant sur la lumière de réception reçue par le récepteur de lumière (19),
dans lequel
l'émetteur de lumière (13, 13', 13") comporte un composant semi-conducteur monolithique (26) ayant une première couche (31) d'émission de lumière et une seconde couche (32) d'émission de lumière, la seconde couche (32) d'émission de lumière définissant une surface lumineuse centrale (39, 39') et la seconde couche (31) d'émission de lumière définissant une surface lumineuse extérieure (40) entourant la surface lumineuse centrale (39, 39'),
**caractérisé en ce que**
la première couche (31) d'émission de lumière est réalisée pour émettre de la lumière rouge et la seconde couche (32) d'émission de lumière est réalisée pour émettre de la lumière infrarouge,
un dispositif de commande (27) est associé à l'émetteur de lumière (13), qui est réalisé pour piloter individuellement la première couche (31) d'émission de lumière et la seconde couche (32) d'émission de lumière, et
le dispositif de commande (27) est réalisé pour n'activer que temporairement la première couche (31) d'émission de lumière pendant le fonctionnement du capteur optoélectronique (11), et
le dispositif de commande (27) est réalisé pour n'activer la première couche (31) d'émission de lumière que lorsque le capteur optoélectronique (11) est en mode d'orientation et/ou lorsqu'un critère de commutation du capteur optoélectronique (11) est satisfait, et/ou lorsque le capteur optoélectronique (11) est dans un état de commutation donné.

2. Capteur optoélectronique selon la revendication 1,
**caractérisé en ce que**
la première couche (31) d'émission de lumière est réalisée pour émettre une lumière quasi-monochromatique dans la plage de longueur d'ondes de 600 nm à 780 nm, et/ou
la seconde couche (32) d'émission de lumière est réalisée pour émettre une lumière quasi-monochromatique dans la plage de longueur d'ondes de plus de 780 nm à 2000 nm.

3. Capteur optoélectronique selon la revendication 1 ou 2,
**caractérisé en ce que**
la première couche (31) d'émission de lumière et la seconde couche (32) d'émission de lumière sont empilées, déposées de préférence en se suivant directement sur un substrat commun (30) du composant semi-conducteur monolithique (26).

4. Capteur optoélectronique selon la revendication 3,
**caractérisé en ce que**
la couche (32) d'émission de lumière inférieure située plus près du substrat (30) présente une bande interdite plus faible que celle de la couche (31) d'émission de lumière supérieure, située plus loin du substrat (30), et/ou la seconde couche (32) d'émission de lumière est la couche inférieure située plus près du substrat (30).

5. Capteur optoélectronique selon l'une des revendications 3 ou 4,
**caractérisé en ce que**
au moins une couche miroir est agencée entre le substrat (30) et la couche (32) d'émission de lumière inférieure située plus près du substrat (30).

6. Capteur optoélectronique selon l'une des revendications 3 à 5,
**caractérisé en ce que**
la couche (31) d'émission de lumière supérieure située plus loin du substrat (30) ne recouvre que partiellement la couche (32) d'émission de lumière inférieure située plus près du substrat (30), et dans une zone non recouverte de la couche inférieure (32) d'émission de lumière est prévu au moins un contact central (37) pour contacter la couche (32) d'émission de lumière inférieure située plus près du substrat (30).

7. Capteur optoélectronique selon l'une des revendications 1 ou 2,
**caractérisé en ce que**
la première couche (31) d'émission de lumière et la seconde couche (32) d'émission de lumière sont séparées latéralement dans l'espace l'une de l'autre.

8. Capteur optoélectronique selon l'une des revendications précédentes,
**caractérisé en ce que**
la surface lumineuse centrale (39, 39') est de forme circulaire ou ovale, et/ou
la surface lumineuse extérieure (40) est en forme d'anneau de cercle fermé ou en forme d'anneau de cercle segmenté.

9. Capteur optoélectronique selon l'une des revendications précédentes,
**caractérisé en ce que**
la première couche (31) d'émission de lumière et la seconde couche (32) d'émission de lumière sont agencées concentriquement sur un substrat commun (30) du composant semi-conducteur monolithique (26).

10. Capteur optoélectronique selon l'une des revendications précédentes,
**caractérisé en ce que**
le composant semi-conducteur monolithique (26) constitue la seule source de lumière de l'émetteur de lumière (13).

11. Capteur optoélectronique selon l'une des revendications précédentes,
**caractérisé en ce que**
l'émetteur de lumière (13) comprend une optique d'émission (20) chromatiquement corrigée, et en particulier l'optique d'émission (20) chromatiquement corrigée présente au moins sensiblement la même distance focale pour la lumière rouge émise par la première couche (31) d'émission de lumière et pour la lumière infrarouge émise par la seconde couche (32) d'émission de lumière.

12. Capteur optoélectronique selon la revendication 11,
**caractérisé en ce que**
l'émetteur de lumière (13) est réalisé sous forme d'achromat, l'achromat comprenant de préférence une combinaison d'une structure optique réfractive et d'une structure optique diffractive et/ou étant réalisé en matière plastique.

13. Capteur optoélectronique selon l'une des revendications précédentes,
**caractérisé en ce que**
le capteur optoélectronique (11) est réalisé sous forme de détecteur optique, par exemple sous forme de détecteur de lumière alternante, de détecteur de triangulation, de détecteur de luminescent ou de détecteur de contraste, ou **en ce que**
le capteur optoélectronique (11) est réalisé sous forme de barrière lumineuse unidirectionnelle ou sous forme de barrière lumineuse de réflexion, ou **en ce que**
le capteur optoélectronique (11) est réalisé sous forme de capteur de couleurs.
